(19) Europäisches Patentamt
European Patent Office
Office européen des brevets

(11) Veröffentlichungsnummer : **0 097 864**
**B1**

(12) # EUROPÄISCHE PATENTSCHRIFT

(45) Veröffentlichungstag der Patentschrift : **12.11.86**

(51) Int. Cl.[4] : **G 03 C 1/68**, C 08 F 20/26, C 08 F 20/28, C 08 F 20/30

(21) Anmeldenummer : **83105776.5**

(22) Anmeldetag : **13.06.83**

(54) **Photopolymerisierbares Gemisch und damit hergestelltes photopolymerisierbares Kopiermaterial.**

(30) Priorität : **21.06.82 DE 3223105**
**27.07.82 DE 3227913**

(43) Veröffentlichungstag der Anmeldung : **11.01.84 Patentblatt 84/02**

(45) Bekanntmachung des Hinweises auf die Patenterteilung : **12.11.86 Patentblatt 86/46**

(84) Benannte Vertragsstaaten : **DE FR GB**

(56) Entgegenhaltungen :
**DE-A- 2 026 311**
**DE-A- 2 909 379**
**FR-A- 2 344 870**
**GB-A- 1 566 125**
**US-A- 4 230 790**
**Die Akte enthält technische Angaben, die nach dem Eingang der Anmeldung eingereicht wurden und die nicht in dieser Patentschrift enthalten sind.**

(73) Patentinhaber : **HOECHST AKTIENGESELLSCHAFT**
**Postfach 80 03 20**
**D-6230 Frankfurt am Main 80 (DE)**

(72) Erfinder : **Dönges, Reinhard, Dr.**
**Oranienstrasse 1**
**D-6232 Bad Soden (DE)**
Erfinder : **Horn, Klaus, Dr.**
**Lessingstrasse 53**
**D-6238 Hofheim/Ts. (DE)**

**EP 0 097 864 B1**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue St-Denis, 75001 Paris, France

**Beschreibung**

Die Erfindung betrifft ein photopolymerisierbares Gemisch, das als wesentliche Bestandteile (a) eine radikalisch polymerisierbare Verbindung mit endständigen Acryl- oder Methacrylsäureestergruppen, (b) ein polymeres Bindemittel und (c) einen durch Strahlung aktivierbaren Polymerisationsinitiator enthält.

Derartige photopolymerisierbare Gemische sind z. B. aus den US-A 2 760 863, 3 060 023 und 3 149 975 bekannt. Als polymerisierbare ethylenisch ungesättigte Verbindungen werden dort niedermolekulare und hochmolekulare Verbindungen mit endständigen bzw. seitenständigen Vinyl- oder Vinylidengruppen, insbesondere Acryl- und Methacrylsäureester von niedermolekularen oder hochmolekularen Polyhydroxyverbindungen, beschrieben. In der Praxis haben sich bisher fast ausschließlich photopolymerisierbare Materialien auf der Basis solcher Ester als polymerisierbare Verbindungen durchgesetzt. Von diesen sind es insbesondere die niedermolekularen Vertreter, die in der Technik bevorzugt eingesetzt werden.

Bei der Verarbeitung von photopolymerisierbaren Materialien der angegebenen Gattung ist es notwendig, den Einfluß des Luftsauerstoffs auf die radikalische Polymerisation auszuschalten oder so weit wie möglich zu unterdrücken. Das erfolgt zumeist dadurch, daß man die photopolymerisierbare Schicht mit einen abziehbaren sauerstoffundurchlässigen Deckblatt (US-A 3 060 026) oder mit einer sauerstoffundurchlässigen Deckschicht abdeckt, die in dem Entwickler löslich ist (US-A 3 458 311). Hierdurch wird verhindert, daß während der lichtinduzierten Polymerisation Sauerstoff in die Schicht eindiffundiert und dort zu Kettenabbruchreaktionen führt, die sich in einer unvollständigen Polymerisation und damit geringeren Lichtempfindlichkeit auswirken.

Der Nachteil der bekannten Materialien liegt in dem zusätzlichen Arbeitsschritt, der für das Aufbringen von Deckfolie oder Deckschicht erforderlich ist. Weiterhin wird die Bildauflösung bei Verwendung selbsttragender Deckfolien, die in der Regel eine Dicke um 20 µm haben, beim Kontaktkopieren verschlechtert. Deckschichten, die im Entwickler löslich sind, haben einen rascheren Verbrauch desselben und eine zusätzliche Abwasserbelastung zur Folge. Man hat deshalb versucht, photopolymerisierbare Materialien herzustellen, die auch ohne Deckschicht eine ausreichende Lichtempfindlichkeit bei der bildmäßigen Polymerisation zeigen.

In der DE-A 2 830 143 wird ein derartiges Material beschrieben, das bestimmte polymerisierbare Verbindungen mit höherem Molekulargewicht und bestimmte Initiator-systeme enthält und daher eine geringe Sauerstoffempfindlichkeit aufweist. Als polymerisierbare Verbindungen werden Acryl- bzw. Methacrylsäureester verwendet, die durch Umsetzen von Acryl- oder Methacrylsäure mit Bis-epoxyverbindungen erhalten werden.

Ähnliche Materialien werden in der DE-A 2 602 410 beschrieben, die bevorzugt zur Herstellung von Photoresistbildern verwendet werden.

Diese bekannten Materialien haben neben einer Reihe von Vorteilen den Nachteil, daß sich mit ihnen nur bestimmte erwünschte Eigenschaften einstellen lassen. So ist es z. B. erwünscht, daß photopolymerisierbare Schichten, die ohne sauerstoffhemmende Deckschicht verwendet werden sollen, nicht klebrig, jedoch flexibel sind und keine Tendenz zur Kristallisation zeigen. Es ist im allgemeinen nicht möglich, eine derartige Kombination von Eigenschaften ohne Zusatz anderer Monomerer zu erreichen, wodurch wiederum andere vorteilhafte Eigenschaften beeinträchtigt werden.

Aus der FR-A 2 344 870 sind photopolymerisierbare Gemische für die Herstellung von Trockenresistmaterialien bekannt, die als photopolymerisierbare Monomere Alkandiol-bis-[(2-(meth)acryloyloxyethyl)carbonate] enthalten.

Aus der US-A 4 230 790 sind photopolymerisierbare Gemische bekannt, die polymerisierbare Verbindungen sehr ähnlicher Struktur enthalten. Sie enthalten anstelle der zentralen Alkandiol-bis-kohlensäuregruppierung eine Alkylendicarbonsäure- oder Phenylendicarbonsäuregruppierung.

Der Erfindung liegt die Aufgabe zu Grunde, durch Strahlung polymerisierbare Gemische zu formulieren, die sich durch hohe Strahlungsempfindlichkeit auszeichnen, die nicht kristallisierbar sind und trotzdem Schichten mit nicht klebender Oberfläche herzustellen gestatten, besonders kann, wenn auf eine Sauerstoff abschirmende Deckschicht verzichtet wird.

Die Erfindung geht aus von einem Gemisch, das durch Strahlung polymerisiert werden kann und als wesentliche Bestandteile

a) eine radikalisch polymerisierbare Verbindung mit endständigen Acryl- oder Methacrylsäureestergruppen,

b) ein polymers Bindemittel.

c) einen durch Strahlung aktivierbaren Polymerisationsinitiator

enthält.

Das erfindungsgemäße Gemisch ist dadurch gekennzeichnet, daß es als polymerisierbare Verbindung (a) eine Verbindung einer der allgemeinen Formeln

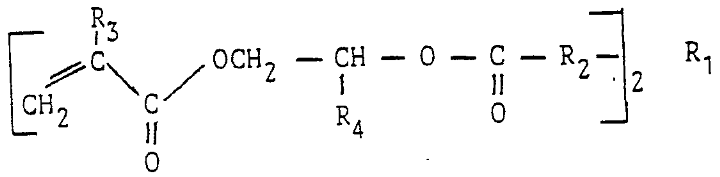

(I)

oder

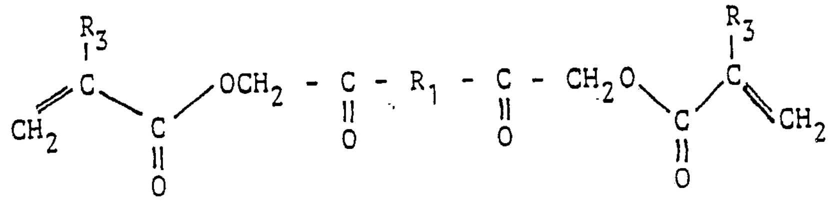

(II)

enthält, worin

$R_1$ eine Phenylen-, Biphenyldiylgruppe oder eine aus zwei über eine Brücke verbundenen Phenylenresten gebildete Gruppe ist, wobei die Brücke ein Sauerstoff- oder Schwefelatom, eine Sulfongruppe, eine gegebenenfalls substituierte Alkylen- oder Cycloalkylengruppe oder eine Gruppe der Formel (O-Alkylen)$_n$O mit n = 1-3 ist,

$R_2$ ein Sauerstoffatom oder die Gruppe $CH_2—CH_2—CO$,

$R_3$ ein Wasserstoffatom oder ein Methylrest und

$R_4$ ein Wasserstoffatom oder der Rest

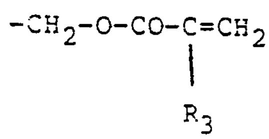

ist.

Beispiele für Gruppen $R_1$ sind Phen-1,4-ylen, Phen-1,3-ylen, Biphenyl-4,4′-diyl, Tol-2,4-ylen, 1,3-Xyl-4,6-ylen und 1,1,1-Triphenyl-ethan-4,4′-ylen. Bevorzugt werden Gruppen, in denen zwei Phenylgruppen durch ein Sauerstoff- oder Schwefelatom oder durch eine substituierte Alkylengruppe, insbesondere durch ein Sauerstoffatom oder eine durch ein Carbonsäureestergruppe substituerte Alkylengruppe, verbunden sind.

Die in dem erfindungsgemäßen Gemisch enthaltenen polymerisierbaren Verbindungen lassen sich nach bekannten Verfahren herstellen. So können z. B. mehrwertige Phenole $HO—R_1—OH$ durch Umsetzen mit Phosgen (wie z. B. von H. Schnell und L. Bottenbruch in Makromolekulare Chemie, *57*, 1 (1962) beschrieben) in die entsprechenden Bis-Chlorkohlensäure-arylester übergeführt werden. Durch anschließende Reaktion mit β-Hydroxyethylmethacrylat oder mit 1,3-Bis-(methacryloyl)-glycerin werden Verbindungen der allgemeinen Formel I mit $R_2$ = Sauerstoff erhalten.

Durch Acylierung aromatischer Verbindungen mit Chloracetylchlorid unter den Bedingungen der Friedel-Crafts-Reaktion werden (z. B. nach A. Dechamp, J. P. Tortei und E. Maréchal, Bull. Soc. chim, France *1972,* 3234) Chloracetyl-Aromaten gebildet, welche sich mit Acryl- oder Methacrylsäure zu polymerisierbaren Verbindungen der allgemeinen Formel II umsetzen lassen.

Wird als Acylierungskomponente bei der Friedel-Crafts-Reaktion Bernsteinsäureanhydrid eingesetzt, so werden ω-Carboxylpropiophenonderivate erhalten, deren Veresterung mit Hydroxyalkylacrylat bzw. -methacrylat polymerisierbare Verbindungen der allgemeinen Formel I mit $R_2 = CH_2CH_2CO$ liefert.

Die erfindungsgemäßen photopolymerisierbaren Gemische enthalten ferner polymere Bindemittel. Es können eine Vielzahl löslicher organischer Polymerisate Einsatz finden.

Als Beispiele seien genannt : Polyamide, Polyvinylester, Polyvinylacetale, Polyvinylether, Polyacrylsäureester, Polymethacrylsäureester, Polyester, Alkydharze, Polyacrylamid, Polyvinylalkohol, Polyethylenoxid, Polydimethylacrylamid, Polyvinylmethylformamid, Polyvinylmethylacetamid sowie Mischpolymerisate der Monomeren, die die aufgezählten Homopolymerisate bilden.

Ferner kommen als Bindemittel Naturstoffe oder umgewandelte Naturstoffe in Betracht, z. B. Gelatine oder Celluloseether.

Mit Vorteil werden Bindemittel verwendet, die in wäßrigalkalischen Lösungen löslich oder mindestens quellbar sind, da sich Shichten mit solchen Bindemitteln mit den bevorzugten wäßrigalkalischen Entwicklern entwickeln lassen. Derartige Bindemittel können z. B. die folgenden Gruppen enthalten : $—COOH$, $—PO_3H_2$, $—SO_3H$, $—SO_2NH_2$, $—SO_2—NH—CO—$. Als Beispiele hierfür seien genannt : Maleinatharze, Polymerisate aus N-(p-Tolylsulfonyl)-carbaminsäure-(β-methacryloyloxyethyl)-ester und Mischpolymerisate dieser und ähnlicher Monomerer mit anderen Monomeren, ferner Methylmethacrylat-Methacrylsäure-Copolymerisate, oder Mischpolymerisate aus Methacrylsäure, Alkylmethacrylaten und Methylmethacrylat und/oder Styrol, Acrylnitril u. a.

Vorzugsweise werden jedoch Styrol-Maleinsäureanhydrid- oder Styrol-Maleinsäureester-Mischpolymerisate verwendet.

Als Fotoinitiatoren können eine Vielzahl von Substanzen Verwendung finden. Beispiele sind Benzoin, Benzoinether, Mehrkernchinone, z. B. 2-Ethyl-anthrachinon, Acridinderivate, z. B. 9-Phenyl-acridin, 9-p-Methoxyphenyl-acridin, 9-Acetylamino-acridin, Benz(a)acridin ; Phenazinderivate, z. B. 9,10-Dimethyl-benz(a)phenazin, 9-Methyl-benz(a)phenazin, 10-Methoxy-benz(a)phenazin, Chinoxalinderivate, z. B. 6,4',4"-Trimethoxy-2,3-diphenyl-chinoxalin, 4',4"-Dimethoxy-2,3-diphenyl-5-aza-chinoxalin- oder Chinazolinderivate.

Die erfindungsgemäßen Gemische können außer Monomeren, Bindemitteln und Fotoinitiatoren noch eine Reihe weiterer üblicher Zusätze enthalten, z. B. Inhibitoren zur Verhinderung der thermischen Polymerisation der Monomeren, Wasserstoffdonatoren, sensitometrische Regler, Farbstoffe, Farbpigmente und ungefärbte Pigmente.

Diese Bestandteile sind zweckmäßig so auszuwählen, daß sie in dem für den Initiierungsvorgang wichtigen aktinischen Strahlungsbereich möglichst nicht zu stark absorbieren.

Als aktinische Strahlung soll jede Strahlung verstanden werden, deren Energie mindestens der des kurzwelligen sichtbaren Lichts entspricht. Geeignet ist insbesondere langwellige UV-Strahlung, aber auch Elektronen-, Röntgen- und Laserstrahlung.

Die erfindungsgemäßen Gemische ergeben fotopolymerisierbare Schichten mit hoher Lichtempfindlichkeit. Diese ist auch dann gegeben, wenn auf eine Sauerstoff abschirmende Deckschicht verzichtet wird. Die Schichten zeigen auch ohne Deckschicht keine Klebeneigung und sind im belichteten Zustand beständig gegen alkalische Entwickler und saure alkoholische Wischwässer.

Die Herstellung der lichtempfindlichen Materialien unter Verwendung des erfindungsgemäßen Gemischs erfolgt in bekannter Weise. So kann man dieses in einem Lösungsmittel aufnehmen und die Lösung bzw. Dispersion durch Gießen, Sprühen, Tauchen oder Antragen mit Walzen auf den vorgesehenen Träger als Film aufbringen und anschließend trocknen.

Die Kopierschichten werden in bekannter Weise belichtet und entwickelt. Als Entwickler sind wäßrige, vorzugsweise wäßrig-alkalische Lösungen, z. B. von Alkaliphosphaten oder Alkalisilikaten, geeignet, denen gegebenenfalls kleine Mengen an mischbaren organischen Lösungsmitteln und Netzmitteln zugesetzt werden können. Gewünschtenfalls können auch organische Lösungsmittel oder Gemische davon als Entwickler verwendet werden.

Die erfindungsgemäßen Gemische eignen sich besonders in Form eines vorsensibilisierten Kopiermaterials auf einem geeigneten Träger, z. B. Aluminium oder Zink, für die fotomechanische Herstellung von Offsetdruckplatten. Sie sind ferner für die Herstellung von Trockenresistfolien, Reliefbildern, Siebdruckschablonen und Farbprüffolien geeignet, außerdem ist eine Verwendung als Photoresistlösung möglich.

Im Folgenden wird zunächst die Herstellung der polymerisierbaren Verbindungen beschrieben. Die daran anschliessenden Beispiele erläutern einzelne Ausführungsformen des erfindungsgemäßen Gemisches. Die eingesetzten Mengen der Schichtbestandteile sind in Gewichtsteilen (Gt) angegeben. Prozentzahlen und Mengenverhältnisse sind, wenn nichts anderes angegeben ist, in Gewichtseinheiten zu verstehen.

Beispiele für die Herstellung von Verbindungen der allgemeinen Formel I mit $R_2$ = Sauerstoffatom

A. Chlorcarboxylierung von Phenolen der Formel HO—$R_1$—OH

a) In eine Lösung von 75,3 g (0,25 mol) 2,2-Bis(4-hydroxy-phenyl)essigsäurebutylester in 250 ml Toluol werden unterhalb von 5 °C 85 g (0,86 mol) Phosgen eingeleitet. Es wird auf — 10 °C gekühlt und 60,5 g (0,5 mol) Dimethylanilin, gelöst in 60 ml Toluol, werden zugetropft. Nach 15 Stunden Reaktionszeit bei Raumtemperatur wird das überschüssige Phosgen durch Einleiten eines Stickstoffstromes vertrieben. Nach Verdünnen mit 250 ml Toluol wird mehrfach mit Wasser gewaschen und das Lösungsmittel im Vakuum abdestilliert. Es verbleiben 66 g (0,15 mol ; 62 %) 2,2-Bis-(4-chlorcarbonyloxy-phenyl)essigsäurebutylester.

b) Werden entsprechend a) 47,5 g (0,15 mol) 1,1,1-Trichlor-2,2-bis-(4-hydroxy-phenyl)ethan in 200 ml Toluol mit 53 g (0,53 mol) Phosgen in Gegenwart von 36,3 g (0,3 mol) Dimethylanilin umgesetzt, so werden 61 g (0,138 mol ; 92 %) 1,1,1-Trichlor-2,2-bis-(4-chlorcarbonyloxy-phenyl)ethan erhalten.

B. Umsetzung von Chlorcarbonyloxyaromaten mit Hydroxyethylmethacrylaten

a) 17,7 g (50 mmol) 2,2-Bis-(4-chlorcarbonyloxy-phenyl)propan und 0,5 g Hydrochinon werden in 100 ml Toluol gelöst, und bei 20-25 °C werden zuerst 28,6 g (220 mmol) Hydroxyethylmethacrylat, dann 12 g (120 mmol) Triethylamin zugetropft. Nach 5 Stunden wird mit weiteren 100 ml Toluol versetzt und das Reaktionsgemisch mit Wasser gewaschen. Nach Einengen der organischen Phase erhält man 20 g (37 mmol ; 74 %) 2,2-Bis-(4-methacryloyloxyethyloxycarbonyloxy-phenyl)propan (Verbindung 1).

b) 19,1 g (50 mmol) 2,2-Bis-(4-chlorcarbonyloxy-phenyl)essigsäuremethylester werden in 100 ml Toluol gelöst und mit 0,5 g Hydrochinon versetzt. Es werden 28,6 g (220 mmol) Hydroxyethylmethacrylat zugegeben und unter Eiskühlung 32 ml Triethylamin zugetropft, so daß die Temperatur 20 °C nicht übersteigt. Nach 5 Stunden wird mit Wasser versetzt. Die organische Phase wird abgetrennt, die wäßrige mit Toluol nachextrahiert und die vereinigten organischen Phasen wiederholt mit Wasser gewaschen. Nach Abdestillieren des Lösungsmittels verbleiben 22 g (38,6 mmol ; 77 %) 2,2-Bis-(4-methacryloyloxy-

ethyloxycarbonyloxy-phenyl)essigsäuremethylester (Verbindung 5).

c) Zu einer Lösung von 9,6 g (25 mmol) 2,2-Bis-(4-chlorcarbonyloxy-phenyl)essigsäuremethylester und 0,5 g Hydrochinon in 100 ml Toluol werden bei Raumtemperatur 25 g (110 mmol) 1,3-Bismethacryloylglycerin gegeben und bei 10 °C 17 ml Triethylamin zugetropft. Nach 15 Stunden wird wie unter b) aufgearbeitet. Dabei ergeben sich 18 g (23,5 mmol ; 94 %) der Verbindung 6.

d) 16,3 g (50 mmol) 4,4'-Bis-chlorcarbonyloxy-diphenylether und 0,5 g Hydrochinon in 100 ml Toluol werden bei Raumtemperatur mit 28,6 g (0,25 mol) Hydroxyethylmethacrylat versetzt, und anschließend werden unter Eiskühlung 33 ml Triethylamin zugetropft. Nach 15 Stunden wird mit Toluol verdünnt, gut mit Wasser gewaschen und das Lösungsmittel im Vakuum abdestilliert. Es verbleiben 18 g (35 mmol ; 70 %) 4,4'-Bis-(methacryloyloxyethyloxycarbonyloxy)-diphenylether (Verbindung 8).

e) 21,5 g (50 mmol) 1,1-Bis-(4-chlorcarbonyloxy-phenyl)-1-phenyl-ethan und 0,5 g Hydrochinonmonomethylether werden in 100 ml Toluol gelöst, 28,6 g (220 mmol) Hydroxyethylmethacrylat hinzugegeben und durch Zutropfen von 32 ml Triethylamin bei ca. 10 °C zur Reaktion gebracht. Nach dem Aufarbeiten wie unter b) verbleiben 26,4 g (44 mmol ; 88 %) von Verbindung 14.

f) Werden 10,8 g (25 mmol) 1,1-Bis-(4-chlorcarbonyloxy-phenyl)-1-phenyl-ethan und 12,5 g (55 mmol) 1,3-Bis-methacryloyl-glycerin in 100 ml Toluol in Anwesenheit von 0,3 g Hydrochinon durch Zugabe von 17 ml Triethylamin zur Reaktion gebracht und wie oben beschrieben aufgearbeitet, so verbleiben 19,5 g (24,4 mmol ; 98 %) der Verbindung 15.

g) 19,25 g (50 mmol) 1,1-Bis-(4-chlorcarbonyloxy-phenyl)-cyclohexan und 0,5 g Hydrochinonmonomethylether in 100 ml Toluol werden mit 28,6 g (220 mmol) Hydroxyethylmethacrylat versetzt und unter Eiskühlung 34 ml Triethylamin zugetropft. Nach 20 Stunden wird mit der doppelten Menge Toluol versetzt, wiederholt mit Wasser ausgewaschen und das Lösungsmittel im Vakuum abdestilliert. Es verbleiben 23,2 g (40 mmol ; 80 %) 1,1-Bis-(4-methacryloyloxyethoxycarbonyloxy-phenyl)-cyclohexan (Verbindung 17).

h) 9,6 g (25 mmol) 1,1-Bis-(4-chlorcarbonyloxy-phenyl)-cyclohexan und 0,2 g Hydrochinon werden in 100 ml Toluol gelöst, und 14 g 1,3-Bis-methacryloyl-glycerin werden zugegeben. Beim Zutropfen von 17 ml Triethylamin steigt die Temperatur bis ca. 45 °C. Auf 15 Stunden Nachreaktion bei Raumtemperatur folgt die Aufarbeitung wie unter g) beschrieben. Die Ausbeute an Verbindung 18 beträgt 17 g (22 mmol ; 88 %).

(Siehe Tabelle I Seite 6 ff.)

Beispiele für die Herstellung von Verbindungen der allgemeinen Formel II

A. Herstellung von Chloracetylverbindungen

a) Zu einer Suspension von 200 g Aluminiumchlorid in 500 ml trockenem Methylenchlorid werden 81 ml (1,02 mol) Chloracetylchlorid, gelöst in 200 ml Methylenchlorid, und nach einer Stunde 85 g (0,5 mol) Diphenylether, ebenfalls gelöst in 200 ml Methylenchlorid, getropft. Es wird 10 bis 15 Stunden zum Rückfluß erhitzt, auf Eis gegossen, mit konz. Salzsäure angesäuert und mit Methylenchlorid extrahiert. Nach dem Einengen der organischen Phase wird der verbleibende 4,4'-Bis-chloracetyl-diphenylether zweimal aus Toluol/Hexan umkristallisiert. Schmelzpunkt 108 °C (Lit. 102 °C).

b) Wie unter a) werden 84 g (0,5 mol) Diphenylmethan umgesetzt, wobei 50 g (31 %) 4,4'-Bis-chloracetyl-diphenylmethan vom Schmelzpunkt 122-124 °C erhalten werden.

c) Zu einer Mischung von 188 g Phenol, 60 ml Wasser und 120 g Ätznatron werden bei 100 °C 180 g 2,2'-Dibromdiethylether getropft. Nach 16 Stunden wird in Eiswasser gegossen, abgesaugt und aus Essigester umkristallisiert. Man erhält 158 g (80 %) 2,2'-Bis-(phenoxy)diethylether vom Schmelzpunkt 60 °C.

80 g Aluminiumchlorid werden in 200 ml Methylenchlorid suspendiert, und 46 g Chloracetylchlorid werden zugetropft. Nach einer Stunde werden 52 g Bis-(2-phenoxyethyl)ether, gelöst in 80 ml Methylenchlorid, zugetropft, und das Gemisch wird 15 Stunden zum Rückfluß erhitzt. Es wird vorsichtig auf Eis gegossen, mit 200 ml konz. Salzsäure angesäuert, mit Methylenchlorid extrahiert, die organische Phase mit Wasser gewaschen, eingeengt und das Produkt aus Toluol/Hexan umkristallisiert. Es ergeben sich 55 g (32 %) 2,2'-Bis-(4-chloracetyl-phenoxy)-diethylether vom Schmelzpunkt 134 °C.

d) Zu einer Mischung aus 94 g Phenol, 30 ml Wasser und 60 g Natriumhydroxid werden bei 100 °C 160 g 2-Brom-ethylphenylether gegeben. Nach 16 Stunden Reaktionszeit wird in Wasser gegossen, abgesaugt und das Produkt aus Essigester umkristallisiert. Man erhält 90 g (53 %) 1,2-Diphenoxy-ethan vom Schmelzpunkt 95 °C.

120 g Aluminiumchlorid werden in 300 ml Methylenchlorid suspendiert, und 70 g Chloracetylchlorid, in 120 ml Methylenchlorid gelöst, werden zugetropft. Nach einer Stunde wird eine Lösung von 64 g 1,2-Diphenoxyethan zugetropft und das Reaktionsgemisch 15 Stunden zum Rückfluß erhitzt. Es wird auf Eis gegossen und wie unter c) aufgearbeitet. Es werden 45 g (41 %) 1,2-Bis-(4-chloracetyl-phenoxy)-ethan

Tabelle I

Beispiele für Verbindungen der allgemeinen Formel I mit $R_2$ = Sauerstoff und $R_3 = CH_3$

| Verbindung Nr. | $R_1$ | $R_4$ |
|---|---|---|
| 1 | 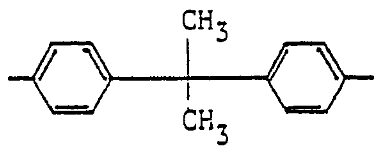 | H |
| 2 | 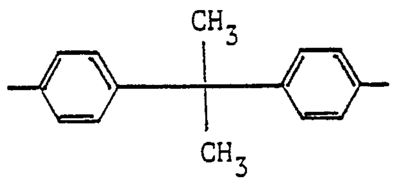 | M 1) |
| 3 | 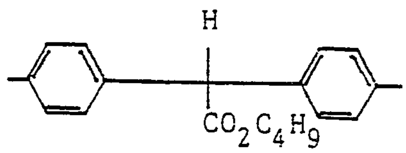 | H |
| 4 | 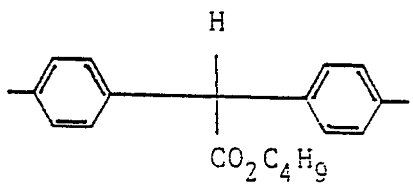 | M |
| 5 | 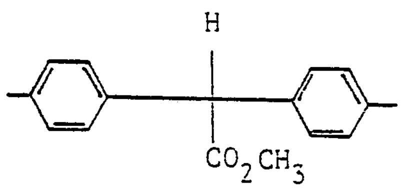 | H |
| 6 | 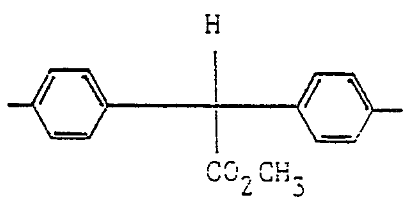 | M |
| 7 | 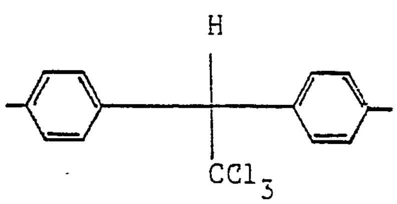 | H |

Tabelle I (Fortsetzung)

| Verbindung Nr. | $R_1$ | $R_4$ |
|---|---|---|
| 8 | 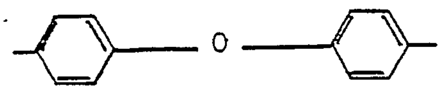 | H |
| 9 | 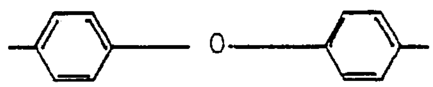 | M |
| 10 | 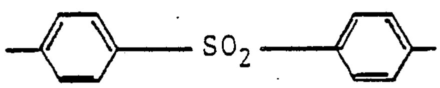 | H |
| 11 | 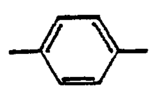 | H |
| 12 | 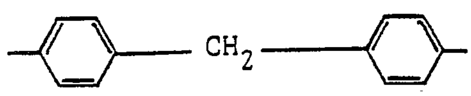 | H |
| 13 | 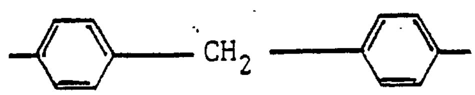 | M |
| 14 | 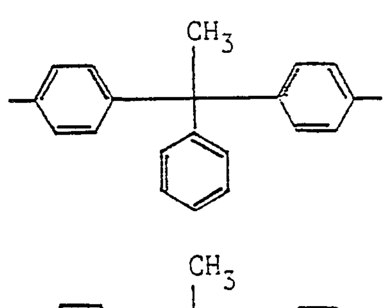 | H |
| 15 | 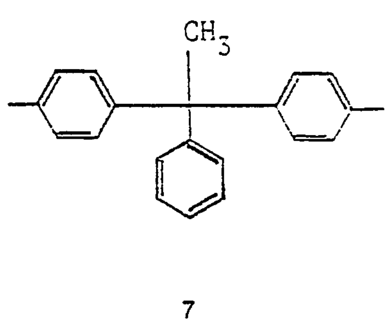 | M |

Tabelle I (Fortsetzung)

| Verbindung Nr. | $R_1$ | $R_4$ |
|---|---|---|
| 16 | 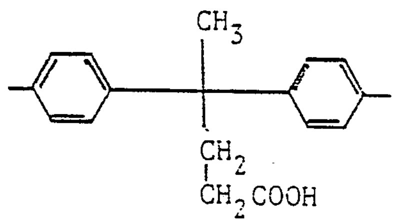 | H |
| 17 | 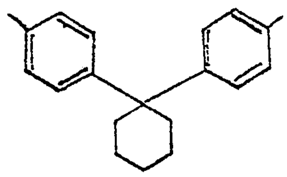 | H |
| 18 | 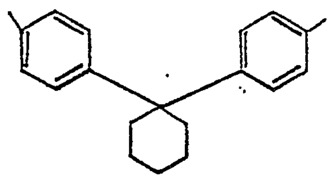 | M |
| 19 | 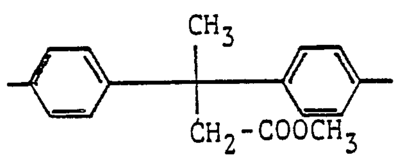 | H |
| 20 | 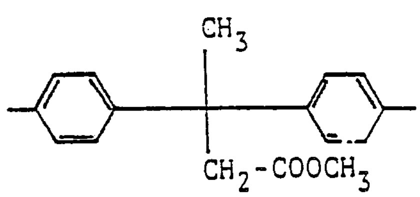 | M |

[1]) M ist der Rest

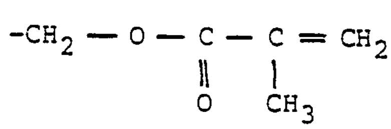

vom Schmelzpunkt 165 °C erhalten.

B. Umsetzung von Chloracetylverbindungen mit (Meth)acrylsäure

a) 70 g 4,4'-Bis-chloracetyl-diphenylether, 60 g Methacrylsäure und 0,2 g Hydrochinon werden in 350 ml Aceton gelöst, mit 100 g Triethylamin versetzt und 5 Stunden zum Rückfluß erhitzt. Es wird vom ausgefallenen Ammoniumsalz abgesaugt, im Vakuum eingeengt, in Methylenchlorid aufgenommen, die organische Phase mit 2 n HCl, 2 n NaOH und mit Wasser gewaschen. Nach dem Einengen wird aus Essigester umkristallisiert, wobei sich 49 g (50 %) der Verbindung 21 vom Schmelzpunkt 103-105 °C ergeben.

b) 25 g 4,4'-Bis-chloracetyl-diphenylsulfid, 19 g Methacrylsäure und 0,2 g Hydrochinon werden in 350 ml Aceton gelöst, 38 g Triethylamin werden zugetropft, und das Gemisch wird 5 Stunden zum Rückfluß erhitzt. Es wird wie unter a) aufgearbeitet und aus Ethanol umkristallisiert, wobei 21 g (66 %) der Verbindung 23 vom Schmelzpunkt 99 °C erhalten werden.

c) 15,4 g 4,4'-Bis-chloracetyl-biphenyl, 0,2 g Hydrochinon und 11 g Acrylsäure werden in 300 ml Aceton gelöst, und 45 g Triethylamin werden zugetropft. Das Reaktionsgemisch wird 5 Stunden zum Rückfluß erhitzt und wie unter a) beschrieben aufgearbeitet. Es werden 13,6 g (72 %) der Verbindung 26 mit einem Schmelzpunkt von ca. 190 °C erhalten.

d) 16 g 4,4'-Bis-chloracetyl-diphenylmethan und 11 g Acrylsäure werden in 300 ml Aceton gelöst und mit 0,1 g Hydrochinon stabilisiert. Nach Zutropfen von 26 g Triethylamin wird 4 Stunden zum Rückfluß erhitzt und, wie unter a) beschrieben, aufgearbeitet. Es ergeben sich nach Umkristallisation aus Essigester 10 g (51 %) der Verbindung 28 vom Schmelzpunkt 118 °C.

e) 20,6 g 2,2'-Bis-(5-chloracetyl-phenoxy)-diethylether und 13 g Methacrylsäure werden wie unter c) beschrieben, umgesetzt, wobei 14,6 g (57 %) der Verbindung 29 mit dem Schmelzpunkt 138 °C erhalten werden.

f) Wird bei der unter e) beschriebenen Umsetzung statt Methacrylsäure die äquivalente Menge Acrylsäure eingesetzt, so werden 18,5 g (77 %) der Verbindung 30 erhalten.

g) 18,4 g 1,2-Bis-(4-chloracethyl-phenoxy)-ethan werden in 300 ml Aceton unter Einwirkung von 45 g Triethylamin mit 13 g Methacrylsäure umgesetzt. Aus dem Reaktionsprodukt werden durch Umkristallisieren aus Essigester 7,2 g (36 %) der Verbindung 31 vom Schmelzpunkt 142-146 °C erhalten.

h) 6 g 1,3-Bis-(4-chloracetyl-phenoxy)-propan und 0,1 g Hydrochinon werden in 200 ml Aceton gelöst. Nach Zugabe von 4,1 g Methacrylsäure werden 14,2 g Triethylamin zugetropft, und das Reaktionsgemisch wird 6 Stunden zum Rückfluß erhitzt. Es wird eingeengt, in Methylenchlorid aufgenommen und mit 2 n Salzsäure, 2 n Natronlauge und Wasser gewaschen. Nach Abdestillieren des Lösungsmittels wird in Essigester aufgenommen und vom unlöslichen Rückstand abfiltriert. Die Ausbeute an Verbindung 33 beträgt 3,6 g (48 %).

(Siehe Tabelle II Seite 10 ff.)

Beispiele für die Herstellung von Verbindungen der allgemeinen Formel I mit $R_2=CH_2CH_2CO$ und $R_3=H$.

a) 22 g Bis-[4-(3-carboxy-propionyl)phenyl]ether und 0,3 g Hydrochinon werden in 350 ml Toluol gelöst und mit 2 ml konzentrierter Schwefelsäure versetzt. Die Reaktionsmischung wird am Wasserabscheider zum Rückfluß erhitzt, und es werden langsam 23,5 g Hydroxyethylmethacrylat zugetropft. Nachdem sich ca. 3 ml einer wäßrigen Phase abgeschieden haben, wird die Toluolphase mit 2 n NaOH gewaschen und eingeengt, wobei 32 g (90 %) der Verbindung 34 erhalten werden.

b) 18,5 g Bis-[4-(3-carboxy-propionyl)phenyl]ether, 0,2 g Hydrochinon und 1,5 ml konzentrierte Schwefelsäure werden in 350 ml Toluol zum Rückfluß erhitzt. Beim Zutropfen von 34 g 1,3-Bis(methacryloyl)-glycerin scheiden nich 2,5 ml Wasser ab. Es wird von dem gebildeten polymeren Rückstand abfiltriert, die organische Phase mit Wasser gewaschen und eingeengt, wobei 31 g (81 %) der Verbindung 35 verbleiben.

c) 38,6 g Bis-[4-(3-carboxy-propionyl)phenyl]sulfid, 3 ml konzentrierte Schwefelsäure, 0,4 g Hydrochinon und 0,4 g Kupfer(I)oxid werden in 350 ml Toluol zum Rückfluß erhitzt, und 27 g Hydroxyethylmethacrylat werden zugetropft. Nachdem sich 4 ml einer wäßrigen Phase abgeschieden haben, wird mit 2 n Natronlauge gewaschen und eingeengt. Die Ausbeute an Verbindung 36 beträgt 56 g (92 %).

d) 18,4 g Bis-[4-(3-carboxy-propionyl)phenyl]methan werden mit 1,5 ml konzentrierter Schwefelsäure, 0,2 g Hydrochinon und 19,4 g Hydroxyethylmethacrylat in 300 ml Toluol zum Rückfluß erhitzt, bis sich 2,3 ml Wasser abgeschieden haben. Danach wird mit 2 n NaOH und Wasser gewaschen und im Vakuum eingeengt. Es verbleiben 20 g (55 %) der Verbindung 37.

e) 17,7 g 4,4'-Bis-(3-carboxy-propionyl)biphenyl werden wie unter d) beschrieben umgesetzt, wobei 26,5 g (92 %) der Verbindung 38 erhalten werden.

Tabelle II

Beispiele für Verbindungen der allgemeinen Formel II

| Verbindung Nr. | $R_1$ | $R_3$ |
|---|---|---|
| 21 | 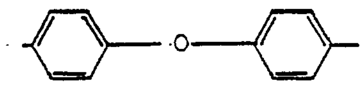 | $CH_3$ |
| 22 | 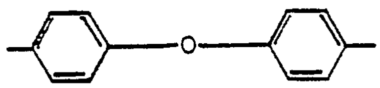 | H |
| 23 | 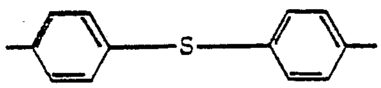 | $CH_3$ |
| 24 | 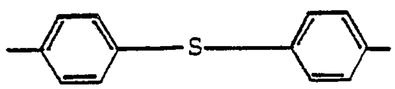 | H |
| 25 | 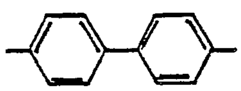 | $CH_3$ |
| 26 | 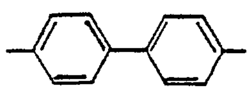 | H |
| 27 | 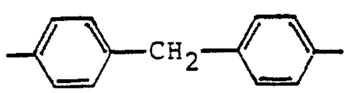 | $CH_3$ |
| 28 | 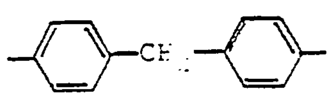 | H |
| 29 | 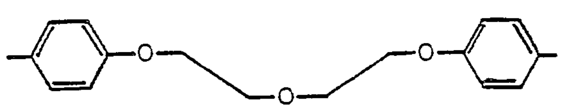 | $CH_3$ |
| 30 | 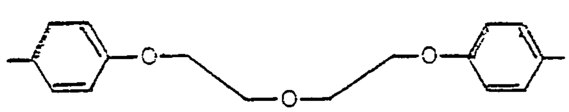 | H |

Tabelle II (Fortsetzung)

| Verbindung Nr. | $R_1$ | $R_3$ |
|---|---|---|
| 31 | 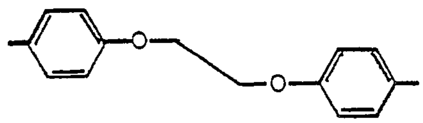 | $CH_3$ |
| 32 | 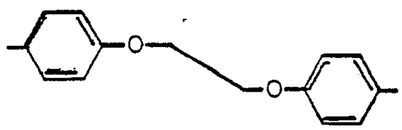 | H |
| 33 | 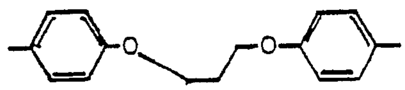 | $CH_3$ |

Tabelle III

Beispiele für Verbindungen der allgemeinen Formel I mit $R_2=CH_2CH_2CO$ und $R_3=H$.

| Verbindung Nr. | $R_1$ | $R_4$ |
|---|---|---|
| 34 | 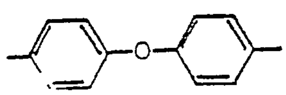 | H |
| 35 | 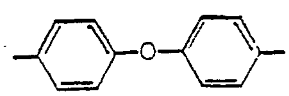 | M 1) |
| 36 | 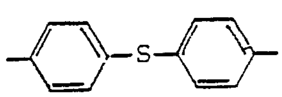 | H |
| 37 | 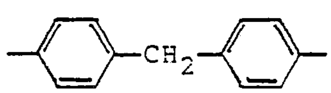 | H |
| 38 | 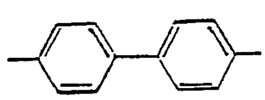 | H |

1) M = $-CH_2-O-C(=O)-C(CH_3)=CH_2$

## Beispiel 1

Als Schichtträger für Druckplatten wurde elektrochemisch aufgerauhtes und anodisiertes Aluminium mit einer Oxidschicht von 3 $g/m^2$ verwendet, das mit einer wäßrigen Lösung von Polyvinylphosphonsäure vorbehandelt worden war.

Es wurde eine Lösung aus :

2 Gt eines Styrol-Maleinsäureanhydrid-Mischpolymerisats mit dem mittleren Molekulargewicht 20 000 und einer Säurezahl von 180-200 (Scripset 540 von Monsanto),
2 Gt Verbindung 4,
0,125 Gt 9-Phenyl-acridin und
0,06 Gt des Azofarbstoffs aus 2,4-Dinitro-6-chlorbenzoldiazoniumsalz und 2-Methoxy-5-acetylamino-N-cyanethyl-N-hydroxyethyl-anilin in
26 Gt Butanon und
14 Gt Butylacetat

auf den oben beschrieben Träger in der Weise aufgeschleudert, daß ein Trockengewicht von 3,7-4 $g/m^2$ erhalten wurde. Dann wurde die Platte 2 Minuten bei 100 °C im Umlufttrockenschrank getrocknet.

Die erhaltene Druckplatte wurde mittels einer 5 kW Metallhalogenidlampe im Abstand von 110 cm zwischen Lampe und Vakuumkopierrahmen unter einem 13-stufigen.

Belichtungskeil mit Dichteinkrementen von 0,15, 40 Sekunden belichtet.

Anschließend wurde die Platte manuell mit einem Entwickler folgender Zusammensetzung entwickelt :

3,0 Gt Natriummetasilikat × 9 Wasser,
0,03 Gt nichtionogenes Netzmittel (Kokosfettalkohol-Polyoxyethylenether mit ca. 8 Oxyethyleneinheiten),
0,003 Gt Antischaummittel,
96,967 Gt vollentsalztes Wasser.

Es wurden 5 vollvernetzte Keilstufen erhalten.

## Beispiel 2

Zu der in Beispiel 1 angegebenen Beschichtungslösung wurden 0,04 g amorphe, hochporöse Kieselsäure, mittlere Teilchengröße 8 µm (Syloid® Al 1) hinzugefügt, und die Dispersion wurde auf den Schichtträger so aufgeschleudert, daß ein Schichtgewicht von 3,5 $g/m^2$ erhalten wurde.

Die Platte wurde in gleicher Weise wie in Beispiel 1 weiterverarbeitet.

Es wurden 5 vollvernetzte Keilstufen erhalten.

Die Druckplatte erreichte im konventionellen Feuchtwerk eine Auflage von 180 000 Bogen, im Alkoholfeuchtwerk eine von 90 000 Bogen.

## Beispiel 3

Die beschichtete Platte aus Beispiel 2 wurde nach dem Trocknen mit einer 15 %igen wäßrigen Lösung von Polyvinylalkohol (12 % Restacetylgruppen, K-Wert 4) beschichtet. Nach dem Trocknen wurde eine Deckschicht mit einem Gewicht von 5 $g/m^2$ erhalten.

Teile der Platte wurden dann mittels einer Metallhalogenidlampe 5, 10, 20 bzw. 40 Sekunden unter einem 13-stufigen Belichtungskeil mit Dichteinkrementen von 0,15 belichtet und danach mit der in Beispiel 1 beschriebenen Entwicklerlösung entwickelt.

In einem weiteren Versuch wurde die Platte nach dem Belichten 5 Sekunden bei 100 °C im Umlufttrockenschrank erhitzt und anschließend entwickelt.

Die folgende Tabelle zeigt, daß die Schicht streng reziprok arbeitet und daß der Nacherhitzungsschritt eine deutliche Zunahme der Anzahl der vollvernetzten Keilstufen zur Folge hat :

| | Belichtungszeit (Sekunden) | | | |
|---|---|---|---|---|
| | 5 | 10 | 20 | 40 |
| Keilstufen ohne Nacherhitzung | 3 | 5 | 7 | 9 |
| Keilstufen mit Nacherhitzung | 8 | 9 | 11 | 13 |

Schichten mit anderen Monomeren (z. B. Trimethylolethantriacrylat) vernetzen unter Sauerstoffeinfluß (d. h. ohne Deckschicht) wesentlich weniger als mit Deckschicht (3 Keilstufen ohne Deckschicht, 9 Keilstufen mit Deckschicht bei 40 Sekunden Belichtungszeit).

Beispiel 4

Eine Beschichtungslösung wurde aus

1 Gt eines Methylmethacrylat-Methacrylsäure-Mischpolymerisats mit dem Molekulargewicht 30 000 und der Säurezahl 117,
1 Gt des in Beispiel 1 angegebenen Styrol-Maleinsäureanhydrid-Mischpolymerisats,
2 Gt der Verbindung 3,
0,125 Gt 9-Phenyl-acridin,
0,07 Gt des in Beispiel 1 beschriebenen blauen Farbstoffs und
0,04 Gt der in Beispiel 2 angegebenen Kieselsäure in
21 Gt Butanon und
11 Gt Butylacetat

hergestellt und auf den in Beispiel 1 beschriebenen Aluminiumträger so aufgeschleudert, daß ein Schichtgewicht von 5 g/m$^2$ erhalten wurde.

Belichtung, Entwicklung und Beurteilung erfolgten wie in Beispiel 1.

Es wurden 4 vollvernetzte Keilstufen erhalten.

Beispiel 5

Auf den in Beispiel 1 angegebenen Schichtträger wurden Lösungen folgender Zusammensetzung so aufgeschleudert, daß ein Schichtgewicht von 3,5 g/qm erhalten wurde :

2 Gt des in Beispiel 1 angegebenen Mischpolymerisats,
1,8 Gt einer der in Tabelle IV angegebenen Verbindungen,
0,5 Gt 9-Phenyl-acridin und
0,05 Gt des Azofarbstoffs aus Beispiel 1 in
23 Gt Butanon,
12 Gt Butylacetat und
12 Gt Ethylenglykolmonomethylether.

Die Platten wurden 40 Sekunden belichtet und mit der in Beispiel 1 angegebenen Entwicklerlösung entwickelt.

Es wurde die folgende Anzahl vollvernetzter Keilstufen erhalten :

Tabelle IV

| Verb.-Nr. | Keilstufen | Verb.-Nr. | Keilstufen |
|---|---|---|---|
| 1 | 2 | 20 | 4 |
| 2 | 1 - 2 | 21 | 4 |
| 3 | 3 - 4 | 22 | 4 |
| 4 | 4 | 23 | 1 - 2 |
| 5 | 5 | 24 | 2 |
| 6 | 3 | 25 | 2 |
| 7 | 2 | 26 | 1 - 2 |
| 8 | 4 | 27 | 3 |
| 9 | 4 | 28 | 2 - 3 |
| 10 | 3 | 29 | 2 |
| 11 | 3 | 30 | 1 - 2 |
| 12 | 4 | 31 | 2 |
| 13 | 2 - 3 | 32 | 3 |

Tabelle IV (Fortsetzung)

| Verb.-Nr. | Keilstufen | Verb.-Nr. | Keilstufen |
|---|---|---|---|
| 14 | 3 | 33 | 2 - 3 |
| 15 | 2 - 3 | 34 | 4 |
| 16 | 3 | 35 | 3 - 4 |
| 17 | 2 | 36 | 2 |
| 18 | 3 | 37 | 3 |
| 19 | 5 | 38 | 2 - 3 |

Beispiel 6

6,5 Gt eines Terpolymerisat aus n-Hexylmethacrylat, Methacrylsäure und Styrol (60 : 30 : 10 Gt) mit einem mittleren Molekulargewicht von ca. 35 000,
5,6 Gt des in Beispiel 1 beschrieben Monomeren,
0,2 Gt 9-Phenyl-acridin,
0,03 Gt des blauen Azofarbstoffs aus Beispiel 1 in
25 Gt Butanon,
2 Gt Ethanol und
1 Gt Butylacetat

wurden auf eine biaxial verstreckte und thermofixierte Polyethylenterephthalatfolie der Stärke 25 µm so aufgeschleudert, daß nach dem Trocknen bei 100 °C ein Schichtgewicht von 35 g/m$^2$ erhalten wurde.

Die so hergestellte Trockenresistfolie wurde mit einer handelsüblichen Laminiervorrichtung bei 120 °C auf eine mit 35 µm starker Kupferfolie kaschierte Phenoplast-Schichtstoffplatte laminiert und 20 Sekunden mit einem handelsüblichen Belichtungsgerät belichtet. Als Vorlage diente eine Strichvorlage mit Linienbreiten und Abständen bis herab zu 80 µm.

Nach der Belichtung wurde die Polyesterfolie abgezogen und die Schicht mit der in Beispiel 1 beschriebenen Entwicklerlösung in einem Sprühentwicklungsgerät 90 Sekunden lang entwickelt.

Die Platte wurde dann 30 Sekunden mit Leitungswasser gespült, 30 Sekunden in einer 15 %igen Ammoniumperoxydisulfat-Lösung angeätzt und sodann nacheinander in den folgenden Elektrolytbädern galvanisiert :

1) 30 Minuten in einem Kupferelektrolytbad der Firma Schlötter, Geislingen/Steige, Typ « Glanzkupfer-Bad »
Stromdichte : 2,5 A/dm$^2$
Metallaufbau : ca. 14 µm

2) 10 Minuten in einem Nickelbad Typ « Norma » der Firma Schlötter, Geislingen/Steige
Stromdichte : 4 A/dm$^2$
Metallaufbau : 9 µm

Die Platte zeigte keinerlei Unterwanderungen oder Beschädigungen.

Die Platte konnte sodann in 5 %iger KOH-Lösung bei 50 °C entschichtet und das freigelegte Kupfer in den üblichen Ätzmedien weggeätzt werden.

Beispiel 7

Die in Beispiel 6 beschriebene Photoresistlösung wurde wie dort beschrieben auf eine mit 35 µm starker Kupferfolie kaschierte Phenoplast-Schichtstoffplatte aufgeschleudert und getrocknet (30 g/m$^2$).

Analog zu Beispiel 6 wurde die Platte belichtet, entwickelt und galvanisiert, wobei anstelle der Vernickelung wie folgt verfahren wurde :

15 Minuten in einem Bleizinnbad LA der Firma Schlötter, Geislingen/Steige
Stromdichte : 1 A/dm$^2$
Metallaufbau : 15 µm

Auch diese Platte zeigte keinerlei Unterwanderungen oder Beschädigungen und ließ sich mit KOH-Lösung entschichten und mit üblichen Ätzmitteln ätzen.

(Siehe Tabelle V Seite 15 f.)

Tabelle V

| Verbindungs-Nr. | Keilstufen |
|---|---|
| 4 | 4 |
| 5 | 5 |
| 19 | 5 |
| 21 | 4 |

Beispiel 8

Auf den in Beispiel 1 angegebenen Schichtträger wurde eine Lösung folgender Zusammensetzung so aufgeschleudert, daß ein Schichtgewicht von 3,5 $g/m^2$ erhalten wurde :

2,6 Gt der Verbindung 19,
6,5 Gt eines Styrol-Maleinsäureester-Mischpolymerisats mit einer Säurezahl von 145-160 und einem Erweichungspunkt von 140-160 °C,
70 Gt Ethylenglykolmonomethylether,
0,1 Gt 9-Phenyl-acridin,
0,035 Gt des in Beispiel 1 angegebenen Azofarbstoffs und
1,0 Gt des umsetzungsprodukts aus 1 mol 2,2,4-Trimethyl-hexamethylendiisocyanat und 2 mol 2-Hydroxy-ethylmethacrylat.

Die beschichtete Platte wurde anschließend 2 Minuten bei 100 °C im Umlufttrockenschrank getrocknet und mit einer Deckschicht wie in Beispiel 3 versehen. An einem Laserite®-Gerät 150 R der Firma Eocom Corp., das mit einem Argon-Ionen-Laser ausgerüstet war, wurde die Platte mit 200 mW und 1 200 L/2,54 cm (5,3 $mJ/cm^2$) bestrahlt. Der Bildkontrast nach der Bestrahlung war gut. Anschließend wurde die Platte mit dem Entwickler von Beispiel 1 entwickelt. Die Zahl der vollvernetzten Keilstufen eines Halbtonstufenkeils betrug bei Belichtung und unmittelbar folgender Entwicklung 3.

Wenn die gleiche Platte in gleicher Weise verarbeitet wurde, jedoch zwischen Belichten und Entwickeln in einem Erhitzungsgerät 7 Sekunden auf 80 °C erhitzt wurde, so wurden 5 Keilstufen erhalten.

Andruck und Auflagendruck wurden in einer Heidelberger Offsetdruckmaschine GTO mit Dahlgren-Feuchtwerk durchgeführt und betrugen 100 000 Bogen. Bei der zwischen-erhitzten Platte erhöhte sich die Auflage auf 150 000 Bogen.

**Patentansprüche**

1. Durch Strahlung polymerisierbares Gemisch, das als wesentliche Bestandteile
a) eine polymerisierbare Verbindung mit endständigen Acryl- oder Methacrylsäureestergruppen,
b) ein polymeres Bindemittel.
c) einen durch Strahlung aktivierbaren Polymerisationsinitiator

enthält, dadurch gekennzeichnet, daß es als polymerisierbare Verbindung (a) eine Verbindung einer der Formeln

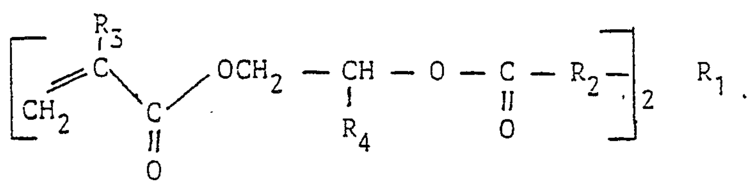

(I)

oder

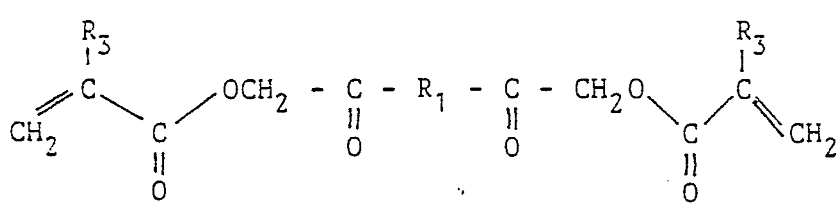

(II)

enthält, worin

$R_1$ eine Phenylen-, Biphenyldiylgruppe oder eine aus zwei über eine Brücke verbundenen Phenylenresten gebildete Gruppe ist, wobei die Brücke ein Sauerstoff- oder Schwefelatom, eine Sulfongruppe, eine gegebenenfalls substituierte Alkylen- oder Cycloalkylengruppe oder eine Gruppe der Formel (O-Alkylen)$_n$O mit n = 1-3 ist,

$R_2$ ein Sauerstoffatom oder die Gruppe $CH_2$—$CH_2$—CO,

$R_3$ ein Wasserstoffatom oder ein Methylrest und

$R_4$ ein Wasserstoffatom oder der Rest

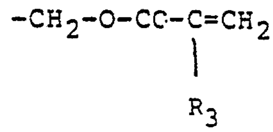

ist.

2. Gemisch nach Anspruch 1, dadurch gekennzeichnet, daß es eine Verbindung einer der Formeln I oder II enthält, worin $R_3$ eine Methylgruppe ist.

3. Gemisch nach Anspruch 1, dadurch gekennzeichnet, daß es eine Verbindung einer der Formeln I oder II enthält, worin $R_1$ eine Diphenylethergruppe ist.

4. Gemisch nach Anspruch 1, dadurch gekennzeichnet, daß es eine Verbindung einer der Formeln I oder II enthält, worin $R_1$ eine Diphenylalkansäureestergruppe ist.

5. Gemisch nach Anspruch 1, dadurch gekennzeichnet, daß es ein polymeres Bindemittel enthält, das in wäßrig-alkalischer Lösung löslich oder mindestens quellbar ist.

## Claims

1. Mixture which is polymerizable by radiation and contains, as the essential components,

a) a polymerizable compound having terminal acrylic or methacrylic acid ester groups,

b) a polymeric binder,

c) a polymerization initiator which can be activated by radiation,

characterized in that it contains, as the polymerizable compound (a), a compound of one of the general formulas

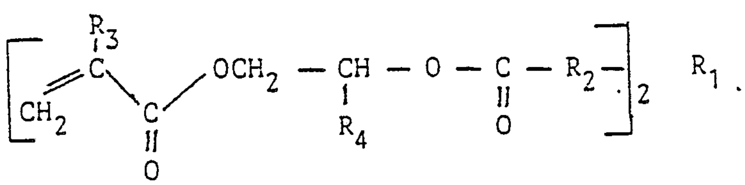

(I)

and

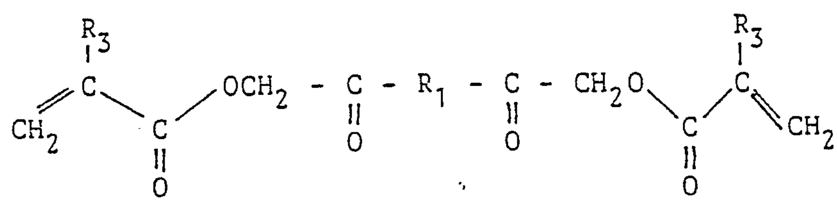

(II)

wherein

$R_1$ is a phenylene group or a biphenyldiyl group or a group formed by two phenylene groups which are linked by a bridge which may be an oxygen or a sulphur atom, a sulfone group, an optionally substituted alkylene group or cycloalkylene group or a group of the formula (O-alkylene)$_n$O with n = 1-3

$R_2$ is an oxygen atom or the group $CH_2$—$CH_2$—CO ;

$R_3$ is a hydrogen atom or a methyl radical ; and

$R_4$ is a hydrogen atom or the radical

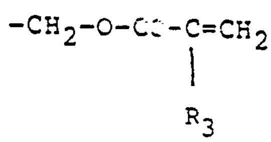

2. Mixture as claimed in Claim 1, containing a compound according to one of the general formulas I or II, wherein $R_3$ is a methyl radical.

3. Mixture as claimed in Claim 1, containing a compound according to one of the general formulas I or II, wherein $R_1$ is a diphenyl ether group.

4. Mixture as claimed in Claim 1, containing a compound according to one of the general formulas I or II, wherein $R_1$ is a diphenyl alkanoic ester group.

5. Mixture as claimed in Claim 1, containing a polymeric binder which in an aqueous alkaline solution is soluble or at least swellable.

**Revendications**

1. Mélange polymérisable par irradiation, contenant en tant que constituants essentiels

a) un composé polymérisable à groupe terminaux acrylate ou méthacrylate,

b) un liant polymère,

c) un initiateur de polymérisation susceptible d'être activé par irradiation,

caractérisé en ce qu'il contient en tant que composé polymérisable (a) un composé correspondant à l'une des formules

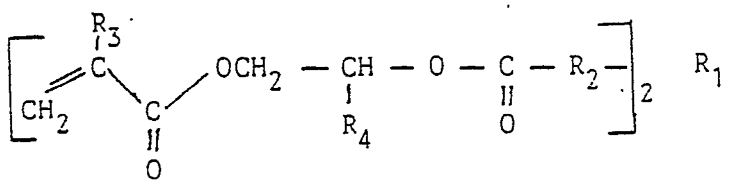

(I)

ou

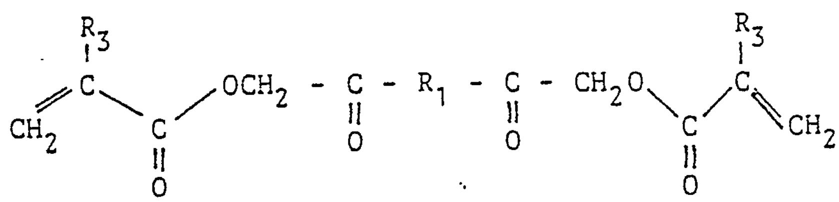

(II)

dans lesquelles

$R_1$ est un groupe phénylène, biphényldiyle ou un groupe formé par deux restes phénylène reliés par un pont, le pont étant un atome d'oxygène ou de soufre, un groupe sulfone, un groupe alkylène ou cycloalkylène, éventuellement substitué, ou un groupe de formule (O-alkylène)$_n$O, n étant égal à 1-3 ;

$R_2$ est un atome d'oxygène ou groupe $CH_2$—$CH_2$—CO ;

$R_3$ est un atome d'hydrogène ou un radical méthyle ; et

$R_4$ est un atome d'hydrogène ou le reste

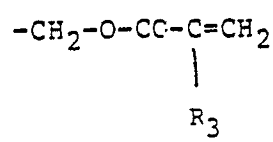

2. Mélange selon la revendication 1, caractérisé en ce qu'il contient un composé correspondant à l'une des formules I ou II, dans lesquelles $R_3$ est un groupe méthyle.

3. Mélange selon la revendication 1, caractérisé en ce qu'il contient un composé correspondant à l'une des formules I ou II, dans lesquelles $R_1$ est un groupe éther diphénylique.

4. Mélange selon la revendication 1, caractérisé en ce qu'il contient un composé correspondant à l'une des formules I ou II, dans lesquelles $R_1$ est un groupe ester d'acide diphénylalcanoïque.

5. Mélange selon la revendication 1, caractérisé en ce qu'il contient un liant polymère qui est soluble ou au moins susceptible de gonfler dans une solution aqueuse alcaline.